# EUROPEAN PATENT SPECIFICATION

(11) **EP 3 875 969 B1**
(45) Date of publication and mention of the grant of the patent: **01.05.2024**
(21) Application number: 21157718.4
(22) Date of filing: 17.02.2021
(51) Int. Cl.: G01R 15/06, G01R 15/16, G01R 29/12

(54) **MULTILAYER ELEMENT FOR ELECTROTECHNICAL APPLICATIONS**
MEHRSCHICHTIGES ELEMENT FÜR ELEKTROTECHNISCHE ANWENDUNGEN
ÉLÉMENT MULTICOUCHE POUR APPLICATIONS ÉLECTROTECHNIQUES

(30) Priority: 17.02.2020 IT 202000003131
(43) Date of publication of application: 08.09.2021
(73) Proprietor: EB Rebosio S.r.l., 25018 Montichiari (BS) (IT)
(72) Inventor: SCARPETTA, Alberto, I-25018 Montichiari, BRESCIA (IT)
(74) Representative: Chimini, Francesco

(56) References cited:
- EP-A1- 2 224 252
- EP-A1- 3 415 929
- EP-A1- 3 578 998
- WO-A1-2018/229675
- WO-A1-2020/016687
- DE-U1- 9 310 388
- US-A1- 2005 122 118
- US-A1- 2007 086 130
- US-A1- 2014 266 178
- US-A1- 2015 192 618
- US-A1- 2018 246 146
- US-A1- 2020 020 466

## Description

The present invention relates to a multilayer element for detecting and/or measuring physical quantities associated with a live electrical conductor, and/or for shielding and/or deflecting the electric field lines generated by the live electrical conductor, where the multilayer element is at least partially embedded or co-molded in a body of insulating material, e.g., an elastomer, a thermoplastic or thermosetting polymer.

It is known to construct electrical shields using micro-stretched or woven networks constituting of a conductive material, for example AISI or brass, flat sheets or with cylindrical-symmetry geometry made of conductive or semi-conductive material, conventionally aluminum alloys, brass, semi-conductive plastics and elastomers.

As for the networks, the tolerance in creating the desired profiles is proportional to the dimensions of the meshes; moreover, the greater the thickness, the less the compatibility of the shield with the overmolding process due to the generation of thermal gradients and expansions.

Networks with traces of lubricant and/or mechanical processing residues generate criticalities in relation to the overmolding process, especially in the case of molding elastomers, thermoplastic and thermosetting polymers. Therefore, cleansing cycles and/or mechanical surface finishing processes, such as for example, surfacing profiles, are required.

The mechanical and electrical performance is dependent on the variation of alloy or production process used.

In the case of micro-stretched networks, there is the risk of the formation of tips in the cutting sections; therefore, there is a need to use mechanical contrivances such as rounding or joining in order to reduce the parasitic effects resulting from the charge concentration.

In the case of a woven network, inelastic deformations can occur both during the overmolding processing and during the handling operation, in particular if the network is used in complex architectures.

The sheet or ring made of conductive or semi-conductive material has a dimensional variability which is inversely proportional to the thickness selected: the greater the thickness, the greater the incompatibility to the overmolding process due to the generation of thermal gradient and the different thermal expansion coefficients.

Thermal gradients, coupling of materials characterized by different thermal expansion coefficients, presence of lubricants and mechanical processing residues, significant surface discontinuities, can be the cause of detachments, cracks, air bubbles, impurities in the insulating material and on the contact surface between insulating material and co-molded architecture, with consequent concentration of charge and electrical stress, therefore the worsening of the performance of the item in operating conditions from a production, electrical, early ageing viewpoint. Prior art HV sensors are found in WO2018/229675, EP3578998, EP3415929, US2005/122118, and US2015/192618.

It is the object of the present invention to suggest a multilayer element capable of overcoming, or in any case significantly reducing, the above drawbacks.

Such an object is achieved by a multilayer element according to claim 1, and a method according to claim 13.

The dependent claims describe preferred or advantageous embodiments of the invention.

The features and advantages of the multilayer element according to the invention will in any case become apparent from the following description of preferred embodiments thereof, given only by way of nonlimiting, indicative example, with reference to the accompanying drawings, in which:
- Figure 1 is a perspective view of a multilayer element not according to the invention;
- Figure 1a is a longitudinal section of the multilayer element in Figure 1;
- Figure 1b shows the multilayer element of Fig. 1a placed around an electrical conductor acting as a source electrode of electric field;
- Figure 1c shows the multilayer element of Fig. 1a placed around an electrical conductor acting both as a source electrode of electric field and as possible sources of interfering electric field placed externally thereto;
- Figures 2-2c are perspective, plan and top views, respectively, of a multilayer element according to the invention, in an embodiment with a screw or mechanical fastening pin thereof with possible extraction function of the signal of interest;
- Figures 3 and 3a are two plan views (top and bottom) of a multilayer element according to the invention, in another embodiment;
- Figure 4 depicts a device for electrotechnical applications when inserting an electrical conductor acting as source of electric field, and which incorporates the multilayer element in Figures 2 and 3 in radial position with respect to the electrical conductor;
- Figures 5 and 5a are a perspective view and an axial section of a multilayer element according to the invention, in another embodiment;
- Figures 6-6b show the multilayer element in Figures 5 and 5a embedded in a device for electrotechnical applications which incorporates an electrical conductor acting as source electrode of electric field.

Examples of multilayer elements according to the invention, for manufacturing electronic circuits on a sublayer made of electrically insulating material, in single or multilayer configuration, are described herein. Such multilayer elements are intended to be embedded in insulating materials, such as thermoplastic, thermosetting polymers and elastomers, such as (not limited to) epoxy resin, LSR, SSR, HCR, EPDM, XLPE, PSU, PEEK, for electrotechnical applications in the medium- and high-voltage domain, independently of the operation frequency, and/or for RF and high frequency commutation and communication systems.

The expression "multilayer element" in the context of the present disclosure therefore means an element which comprises at least one insulating substrate and at least one conductive layer coupled to a side of the insulating substrate.

In particular, the insulating substrate is made from a mineral fiber mesh, e.g., glass fiber, embedded in a matrix of insulating material, preferably epoxy-based. An example of such an insulating substrate is commercially known as FR4, where the abbreviation "FR" is for "flame retardant". Even in the absence or in the presence of varying percentages and forms of minerals, an insulating epoxy-based substrate optimizes the compatibility of the architecture in terms of thermal gradients and expansions in relation to the described overmolding process.

In particular, the conductive layer is made from elastic, conductive, elastomer or ink having a low surface resistivity.

In the continuation of the description, reference is made to the following abbreviations:
FR4: is only the insulating substrate;
FR4SF: is the insulating substrate integral with a conductive layer;
FR4DF: is the insulating substrate integral with two conductive layers;
multilayer FR4: is a sandwich of a number N of insulating layers alternating with a number N+1 of conductive layers.

The multilayer elements suggested herein are made, for example, in order to:
- condition signals acquired by transducers with functions of:
   - voltage presence;
   - magnetic field and/or electric field and respective phase angle analysis;
   - presence and/or distribution feature of partial discharges;
   - temperature/gas/environmental analysis;
- implement the following systems:
   - PWM self-powering and commutation;
   - storing, analyzing, and managing acquired signals;
   - wireless communication;
   - PLC modulation and communication;
   - data sharing;
   - product traceability/identification.

The multilayer elements of the present disclosure allow to obtain multilayer arrangements with one or more functions on a single planar development, i.e., on a single conductive layer.

For example, by using an FR4 multilayer, the overall thickness can be restrained to 0.1-0.4 mm, preferably 0.2 mm.

With such thicknesses, the planar development would be flexible and pre-formable, without compromising the mechanical and electrical properties, thus obtaining solutions adaptable to the geometry of the item in which the multilayer element is embedded.

The multilayer elements of the present disclosure are compatible with processes of:
- thermoforming, in order to obtain the following profiles:
   - lamellar, for creating capacitive couplings or differential transducers;
   - wavy, for obtaining an increased coupling area in small spaces;
   - frustoconical, for creating electric field deflectors;
- electrowelding, so as to obtain cylindrical geometries for planar development;
- COB, for a miniaturization of the circuit transfer functions;
- photoengraving;
- mechanical removal;
- cutting/shearing.

In certain embodiments, masks are formed, on the same layer, or on two opposing conductive layers of the same insulating layer, by means of conductive areas in order to shield, dissipate, deflect and/or guide interfering electric field lines with respect to other conductive areas exposed to the field lines generated by further sources of electric field.

"Interfering electric fields" means electric fields generated by other sources of electric field, different from the electrical conductor to which the multilayer element is intended to be applied.

In certain embodiments, transducers, filters, active and/or passive components, e.g., RFID antennas, can be located on a conductive layer.

In certain embodiments, the multilayer element is crossed by one or more metallized holes suitable to extract the signals obtained, for example by capacitive coupling, from the critical area between the conductive layer and a source of electric field placed under conditions of medium- or high-voltage, without altering the distribution of the field lines, and therefore without penalizing the electric stress which is typical of the area.

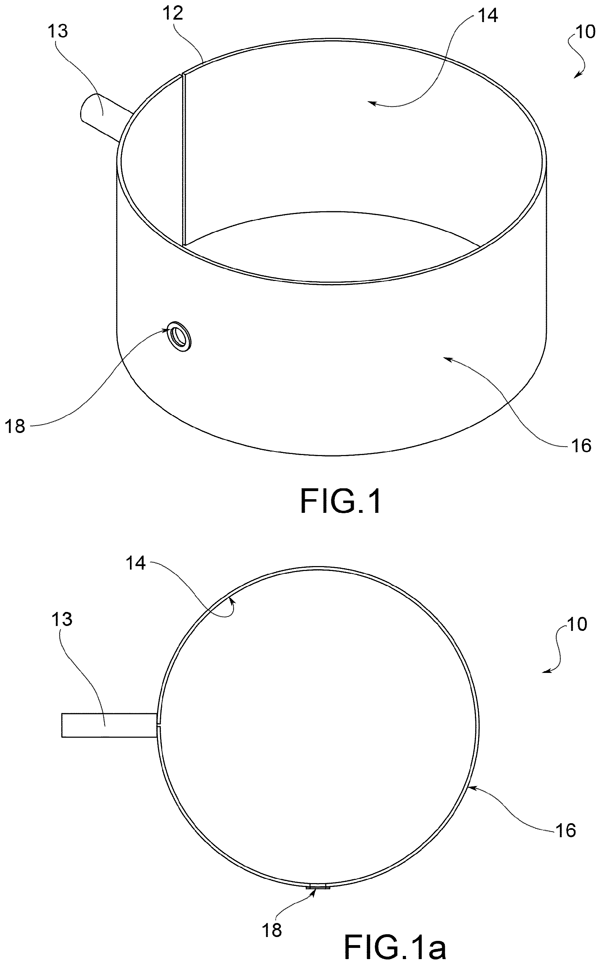

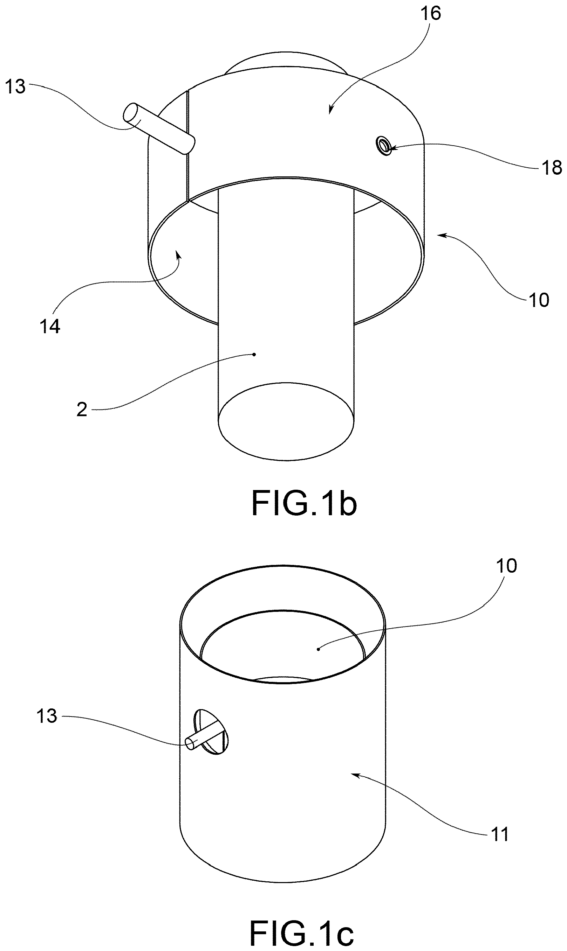

In the examples not part of the invention shown in Figures 1-1c, the multilayer element 10 has a cylindrical shape and therefore is configured to be positioned around a source electrode 2, generator of electric field.

The multilayer element 10 comprises an insulating substrate 12, for example made of FR4, a first electrically conductive layer 14 coupled to the inner side of the insulating substrate, i.e., the side facing the source electrode, so as to be exposed to the electric field lines generated by the source electrode, and a second electrically conductive layer 16 coupled to the outer side of the insulating substrate 12.

The first layer 14 performs the function of capacitive coupling; the second layer 16, when referred to a zero potential or to ground, performs the function of shielding element.

The multilayer element 10 is crossed by a metallized hole 18 which ensures the electric continuity between the first layer 14 and the second layer 16 and allows the electrowelding of metal inserts.

The two conductive surfaces 14 and 16 may be coupled to the insulating substrate 12 through a rolling process.

The cylindrical shape of the multilayer element can be obtained from a planar development of the multilayer element.

In Figure 1c, the multilayer element 10 is inserted coaxially into a cylindrical electrical conductor 11, serving both a function of source electrode of electric field and shield with respect to possible sources of interfering electric field placed externally thereto. The multilayer element 10 is provided with a metal pin 13 or a screw which extends, e.g., radially, from the second layer 16, having the function of mechanical connection to a support structure and/or of electric connection if a single contact pin is sufficient, for example to detect the presence of voltage on the source electrode 2, extracting an alternating voltage VAC which is proportional to the voltage of the source electrode. For example, the metal pin is brought to the alternating voltage VAC obtained by capacitive coupling and can be connected to a warning light system.

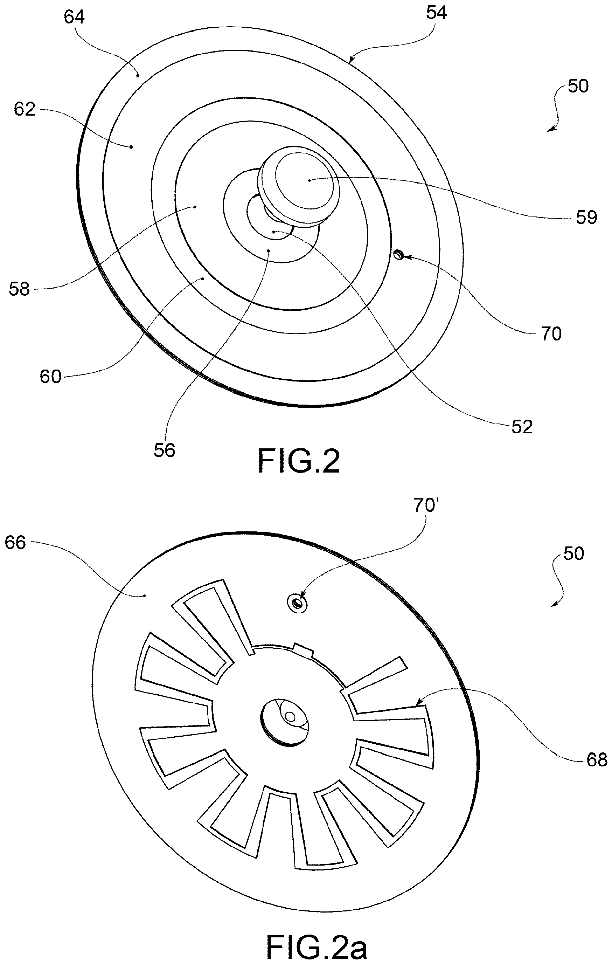

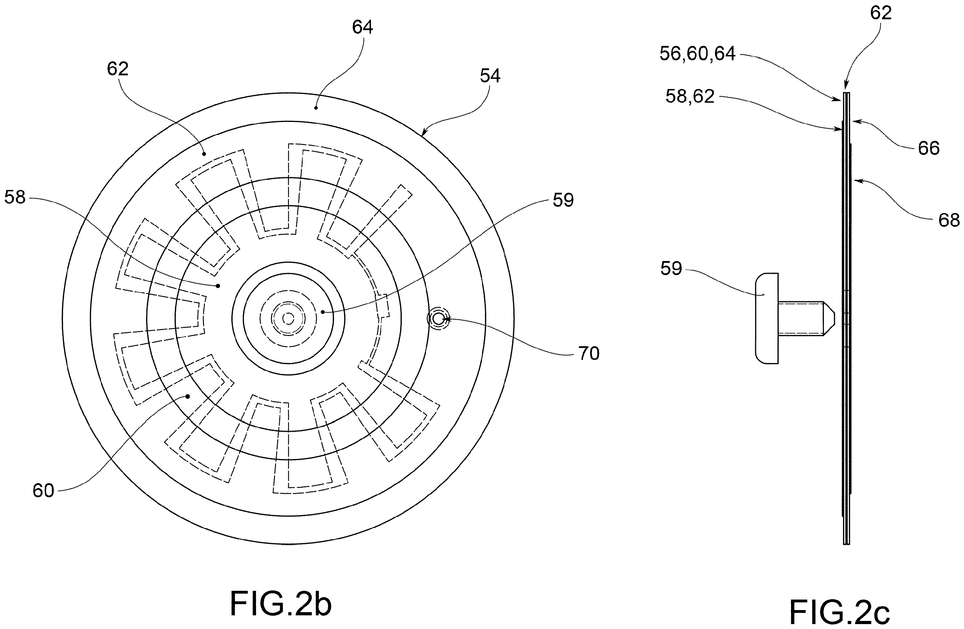

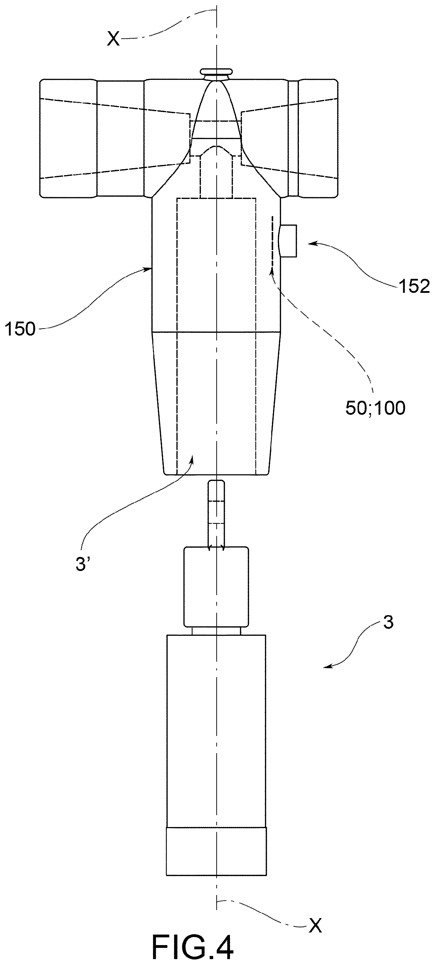

In an embodiment shown in Figures 2-2c, the multilayer element 50 has a planar structure, for example circular in shape. In this embodiment, the multilayer element 50 is suitable to be positioned radially, i.e., sideways, with respect to a source electrode 3 which generates the electric field (shown, for example in Figure 4).

In an embodiment, the multilayer element 50 is crossed by a central opening 52 for a mechanical fastening thereof to a support, for example by means of a screw 59.

The multilayer element 50 comprises an insulating substrate 54, for example which extends for the whole area of the multilayer element.

The multilayer element 50 comprises, on the side facing the source electrode, a radial alternation of conductive and insulating layers, for example which are coaxial to one another.

In the example shown, there are obtained, on the side facing the source electrode, or front/upper side, starting from the central opening 52, a first insulating circular crown 56, for example made of FR4, having the function of separation between the central opening 52 and a second conductive circular crown 58, which forms a first conductive layer having function of capacitive coupling with respect to the electrode, and of electric field shield in favor of a conductive layer opposing the insulating substrate, which is in the shadow zone with respect to the electric field lines generated by the source electrode. A third insulating circular crown 60, for example made of FR4, is formed around this second conductive circular crown 58, which third insulating circular crown electrically separates, i.e., decouples, the second conductive circular crown 58 from a fourth conductive circular crown 62, which makes a second conductive layer having a function both of capacitive coupling with respect to the source electrode and of deflector of electric field and/or of electric shield. Being the outermost conductive crown, the function of field deflector optimizes the immunity of the innermost conductive crowns with respect to interfering, deflected field lines. As described above, the function of shield is in favor of the conductive layer opposing the insulating substrate. A fifth insulating circular crown 64, for example made of FR4, is obtained around the fourth conductive circular crown 62.

In an embodiment, the insulating circular crowns are obtained by removal of a conductive layer coupled to the insulating substrate 54; the remainder of the conductive layer after such a removal therefore forms the conductive circular crowns.

The radially innermost (56) and outermost (64) insulating circular crowns also have a function of reducing the peripheral electric stresses.

The side of the multilayer element 50 opposite to the source electrode can be an insulating layer 66, for example the side of the insulating substrate 54 opposite to the one on which the conductive layers are coupled. In other words, the insulating layer 66 constitutes of the back/lower side of the same insulating substrate 54.

A third lower or back conductive layer 68 is formed on this insulating layer, which creates a circuitry and/or an RFID antenna and/or a COB IC and/or pads and tracks for SMD components.

Moreover, the multilayer element 50 is crossed by a metallized hole 70 which ensures an electric continuity between the conductive circular crown 62 formed on the upper/front layer and the lower/back conductive layer. For example, such a metallized hole 70 on the back/lower side is provided with an annular pad 70' for welding a signal wire for drawing the signal obtained from capacitive coupling without compromising the electric performance in the area between electrode and capacitive coupling, which is considered critical.

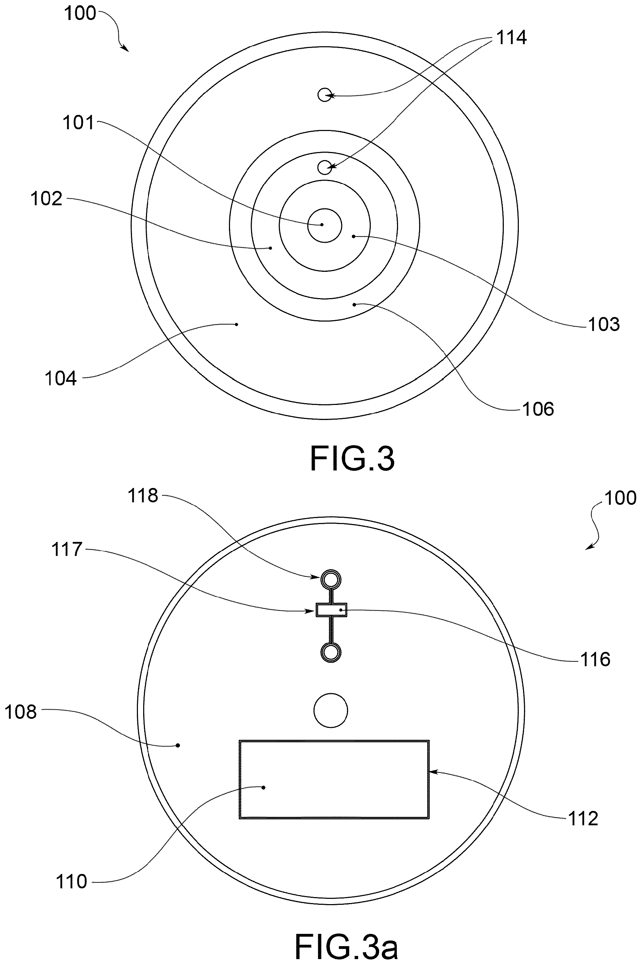

In the embodiment shown in Figures 3 and 3a, the multilayer element 100 has the same planar structure as the multilayer element 50 in Figures 2-2c and has a front, or upper side, i.e., facing the source electrode of electric field 3, with a similar radial alternation of annular conductive layers and of annular insulating layers, which are coaxial to a central through opening 101 suitable to the mechanical fastening to a support structure.

A first conductive layer 102 having for example a function of measuring the electric field through capacitive coupling is obtained around a first annular insulating layer 103 which surrounds the central opening 101.

A second annular conductive layer 104, which is outermost and separated from the first by an insulating layer 106, having the function of voltage detection, for example.

The back, or lower, side of the multilayer element 100 forms a third conductive layer 108, for example with function of planar electric shield when referred to zero potential or to ground.

Again, a fourth conductive layer 110 is formed on the back side of the multilayer element 100, which fourth conductive layer is separated from the third conductive layer 108 by a peripheral insulating layer, or clearance, 112. This fourth conductive layer 110 can, for example have the function of RFID antenna or of other circuit elements, similarly to the conductive layer 68 of the embodiment in Figures 2-2c.

Moreover, the multilayer element 100 is crossed by one or more metallized holes 114 for extracting signals of interest from the electrically critical area, i.e., the area between the source electrode and the front/upper side of the multilayer element, when operating in medium- and high-voltage, and without compromising the electric performance of the system. Indeed, the signals are brought back to welding pads on the back/lower layer, i.e. the one opposite to the critical area, under shielding condition provided either by an interposed conductive layer, referred to zero potential or ground potential, in the case of insulating substrate in multilayer configuration (i.e. formed of a sandwich of insulating layers alternating with conductive layers), or by the same conductive layer which also serves the function of capacitive coupling on the front/upper layer, if the sizes are suitable for ensuring an adequate shadow zone.

On the back or lower side, the metallized holes 114, for example electrically connected to a suitable footprint 116 for welding an SMD output connector, are obtained in a fifth conductive layer 117 which can provide the weldability of a circuitry, pad and strip, for example with functions of conditioning and managing acquired signals, self-powering systems, snubber protection networks.

This fifth conductive layer 117 is separated from the third conductive layer 108 by means of a peripheral insulating layer, or clearance, 118.

In addition to serving the function of planar and peripheral electric decoupling between conductive layers, it should be noted that the insulating layer 103 around the central opening 52; 101 forms an insulated supporting surface for the head of the fastening screw 59. If instead the fastening screw 59 also serves the function of connector for extracting one of the acquired signals, the head is to rest on the conductive layer of interest.

Figure 4 diagrammatically shows the planar multilayer element 50; 100 embedded in a body 150 made of insulating material and in which a conductor, source of electric field 3, is inserted. Figure 4 shows conductor 3 prior to the insertion thereof into a respective seat 3' obtained in body 150.

In the example shown, body 150 is a "T" connector made of an elastomer, e.g., EPDM or LSR. The source electrode 3 constitutes of an MV (medium-voltage) wire ending with a lug to be crimped, which during the installation thereof is inserted and mechanically fastened in the T connector 150.

The planar multilayer element 50; 100 is positioned radially to the source 3 of electric field. In other words, source 3 mainly extends along a source axis X, and the multilayer element 50; 100 lies on a plane which is parallel to the source axis X.

As described above, in an embodiment, the multilayer element 50; 100 is held in position by mechanical screw or connector fastening. The example in Figure 4 shows a connector 152 which is complementary to the SMD connector integral with the multilayer element 50; 100 due to the transmission of the acquired signals to a remote device, or in the shape of complementary insert to screw 59 used for the mechanical fastening, if one signal transmission pin alone is of interest.

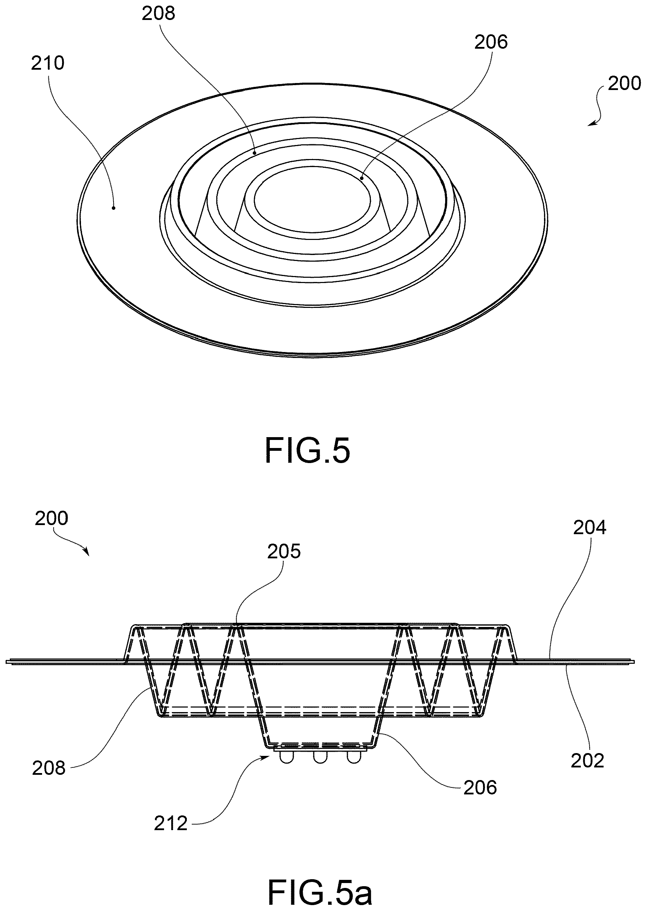

In the embodiment shown in Figures 5 and 5a, the multilayer element 200 has a wavy structure, obtained for example by thermoforming.

The multilayer element 200 has an insulating substrate, 202, for example a Vetronite FR4 plate, on which front or upper side suitable to face a source electrode 230 a first conductive layer 205, for example with function of analyzing the voltage on the source electrode 230, and a second conductive layer 204, for example with function of detecting voltage on the source electrode 230, are coupled.

The insulating substrate 202 serves a support function for the two conductive layers.

The multilayer element has a frustoconical central portion 206, from which end a series of wavy portions 208 coaxial to the central portion 206 radially extend.

In an embodiment, the first conductive layer 205 is integral with and extends over the central portion 206 and over the wavy portions 208.

An annular flat portion 210 can extend from the outermost wavy portion. The second conductive layer 204 is integral with and extends over the flat portion 210, minus a peripheral clearance area required to reduce the peripheral electrical gradient.

Thereby, an increase of the surface exposed to the field lines of an electric field generated by a source electrode 230 placed in front of and aligned with the central portion 206, is obtained. Therefore, the signal detected by capacitive coupling in a small space, which would not be sufficient if it were detected linearly, can be increased.

The back, or lower, side of the frustoconical central portion 206 can be provided with a conductive layer suitable to networks for conditioning the acquired signals, to communication systems such as RFID antennas, COB IC, welding components and active and passive transducers, to the footprint for welding a multipolar SMD connector 212 for mechanically supporting the multilayer element 200 during the co-molding operation and for transmitting the acquired signals to remote devices (if the multilayer element 200 has no through hole for a fastening screw). For example, the multipolar connector 212 is fastened by welding on a conductive pad obtained on the back side of the central portion 206.

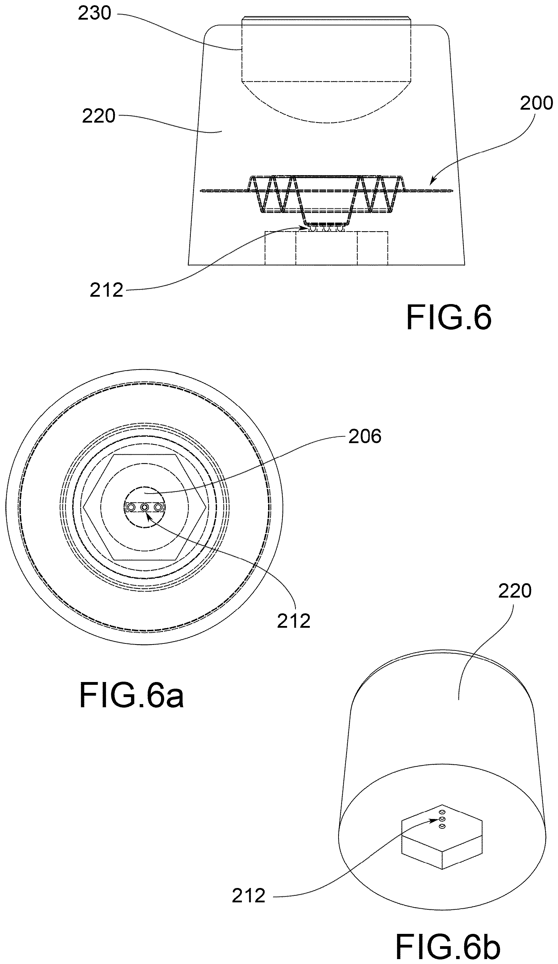

Figures 6-6b show the multilayer element 200 embedded in a body 220 made of an insulating material and in which a source electrode 230 is at least partially embedded.

According to an aspect of the invention, the insulating substrate of the multilayer element is made from a mineral fiber mesh, e.g., glass fiber, embedded in a matrix of insulating material, preferably epoxy-based.

In certain embodiments, several conductive portions electrically decoupled from one another so as to obtain different functions such as RFID antennas, pads and strips suitable to create any type of circuitry, shields and deflectors, capacitive couplings with different conversion ratios, are obtained in the same conductive layer, for example by photoengraving.

Thereby, different functions and/or capacitive couplings suitable to provide a signal which is linearly proportional to the voltage value of the electrical conductor can be obtained on the same conductive layer.

In an embodiment, the multilayer element has a shape obtained by a thermoforming and/or electrowelding and/or photoengraving and/or screen printing process.

It should be noted that the electrical performance of the multilayer element is ensured by virtue of the flexibility and elasticity of at least one of the conductive layers outside the same multilayer element, for example upon co-molding, operating in the medium- and high-voltage domain.

In an embodiment, the multilayer element further has a shape with no sharp edges so as to reduce the formation of electric stress.

In an embodiment, each insulating layer needs to ensure a flexibility of the assembly which, with the conductive components, reaches a recommended thickness of 0.2 mm.

The present invention further relates to a device for electrotechnical applications in the medium- and high-voltage domain, comprising a device body made of an electrically insulating material, at least one electrical conductor at least partially embedded in the device body, and a multilayer element as described above, embedded in the device body in front of, or parallel to, or around the electrical conductor.

In an embodiment, the device is provided with an electrical connector partially embedded in the body made of insulating material for the electrical connection to the multilayer element.

The present invention further relates to a method for measuring, shielding and/or deflecting the field lines of an electric field generated by an electrical conductor at least partially embedded in a device body made of insulating material. In a general embodiment, the method comprises the steps of:
- providing a multilayer element as described above;
- positioning the electrical conductor and the multilayer element in a cavity of a mold for the construction of the device body, the laminated multilayer element being placed parallel or coaxially to the electrical conductor;
- co-molding the electrical conductor and the multilayer element with the insulating material.

In an embodiment, the multilayer element undergoes a thermoforming and/or electrowelding and/or photoengraving and/or screen printing process before it is placed in the mold.

In an embodiment, the insulating substrate undergoes a surface finishing process, for example by means of placement of a layer of silver or chemical gold or tin, before it is placed in the mold.

The use of an insulating layer made from a mineral fiber mesh, e.g., glass fiber, embedded in a matrix of insulating material, preferably epoxy-based, and in particular the use of Vetronite (FR4) allow to achieve a multiplicity of advantages.

Not only can a conductive layer be coupled to an insulating layer, but multilayer laminates with an alternation of conductive and insulating layers (FR4 multilayer) can be obtained.

The variability of the raw material is negligible with respect to the overmolding process.

Increased dimensional stability in the case of mechanical, thermal, and electrical stresses.

The thermal expansion coefficient of the Vetronite optimizes the adhesion between the shielding element and the insulating material in which it is embedded.

Little degradation over time due to the thermal effect.

Absence of carbonization ensuring a structural invariance and consequent absence of early ageing under operating conditions.

Increased control and repeatability of the production process, related to the raw material and the processing thereof.

Processing tolerance in the order of the µm.

Absence of parasitic, intrinsic and/or surface electrical phenomena.

Absence of processing residues.

Absence of significant surface and periphery discontinuities for the overmolding process.

### Null water absorption.

Compatibility with thermoforming, electrowelding, COB, photoengraving, mechanical processing processes.

Therefore, it is a material which is particularly suitable to obtain electric field shielding and deflecting systems, RFID communication, and consequent self-powering systems, single or multiple capacitive coupling, also with different performance, functions, conversion ratios on a single planar development.

The result is a significant structural simplification of the shielding structure.

The electrical insulation is ensured both between coplanar couplings and between parallel layers.

The planar development is flexible and/or pre-formable, without compromising the mechanical and electrical properties, thus obtaining solutions which are useful both for planar and wavy shaped applications.

The use of insulating layers of FR4 with thickness of about 0.2 mm allows to obtain:
- flexibility and moldability and does not create cracks during the shrinkage of the co-molded materials, such as epoxy resin, thermosetting and thermoplastic polymers and elastomers;
- negligible thermal gradients with respect to the overmolding process;
- negligible peripheral electrical stress under operating condition in the medium- and high-voltage domain.

Overall surface and volume size reduced as compared to the prior art.

Absence of meshes and spacers between layers.

The optimization of the processing tolerances as compared to the prior art allows:
- a low production variability with respect to an initial prototype/sample;
- the achievement of accuracy classes in creating superior capacitive couplings;
- complex cabling and/or facilitated circuitry compensations. Analogy with printed circuit.

The surface finish with silver, chemical gold, or tin:
- preserves the conductive layers from oxidization, damage and early ageing during storage, handling, operation;
- allows to optimize the surface distribution of the temperature.

The multilayer structure gives the possibility of shielding/dissipating the interfering electric field by optimizing the immunity of the capacitive coupling created on a parallel second layer.

It should be noted that the multilayer element according to the invention allows the sensors and/or transducers which are integral with the multilayer support, e.g., Hall effect sensors, temperature sensors, capacitive couplings, to be moved as close as possible to the source electrode, which thus benefit from increased accuracy. Indeed, the closer the source is and the more the near-field conditions occur, the less the presence of interferences and damping phenomena of the monitored source is.

In order to meet contingent needs, those skilled in the art may make changes and adaptations to the embodiments of the invention or can replace elements with others which are functionally equivalent without departing from the scope of the following claims. Each of the features described as belonging to a possible embodiment can be achieved irrespective of the other embodiments described.

## Claims

1. A multilayer element (50, 100, 200) for detecting and/or measuring physical quantities associated with a live electrical conductor, the multilayer element having a planar or wavy shape so as to be positioned parallel to or in front of the electrical conductor, under conditions of near electric field in the medium- and high-voltage domain and comprising at least one insulating substrate made from a mineral fiber mesh, such as glass fiber, embedded in a matrix of insulating material, preferably epoxy-based, and at least one conductive layer coupled to a side of the insulating substrate, wherein the insulating substrate also has a function of mechanical support for the multilayer element,
the multilayer element being charaterized in that the at least one conductive layer is made from elastic, conductive, elastomer or ink having a low surface resistivity.

2. A multilayer element according to claim 1, wherein at least one conductive layer has the function of shielding and/or deflecting field lines of the electric field generated by the live conductor so as to allow the operation of the multilayer element in a shadow zone, i.e., in condition of immunity with respect to interfering elements.

3. A multilayer element according to any one of the preceding claims, wherein one or more conductive layers form an RFID antenna suitably polarized and operating in a shadow zone with respect to the measured field source.

4. A multilayer element according to any one of the preceding claims, having a shape obtained by a thermoforming and/or electrowelding and/or photoengraving and/or screen printing process.

5. A multilayer element according to any one of the preceding claims, comprising, on one of the front/top sides thereof and mutually alternating around a central opening for fastening the multilayer element to a support, a first insulating area, a second conductive area which forms a first conductive layer having capacitive coupling function, a third insulating area, a fourth, outermost conductive area, which forms a second conductive layer having capacitive coupling and/or electric field deflector and/or electric shield function.

6. A multilayer element according to the preceding claim, wherein at least one back conductive layer is formed on the back/bottom side thereof, which creates a circuitry which is suitable for the welding process of SMD components and/or an RFID antenna and/or a COB IC and/or an electric pad for SMD connector.

7. A multilayer element according to the preceding claim, wherein a metallized through hole ensures electrical continuity between the first conductive layer and the back conductive layer.

8. A multilayer element according to any one of the preceding claims, having a planar structure with a front side and a back side, wherein a first conductive layer having a function of measuring the electric field by capacitive coupling and a second conductive layer having a function of voltage detection are obtained on the front side, being coaxial, i.e., concentric with each other, and separated by an insulating layer, a third conductive layer with electric shield function, a fourth conductive layer, separated from the third conductive layer by an insulating perimeter layer, being obtained on the back side, said fourth conductive layer being shielded from the capacitive coupling with respect to the source electrode and having the function of a shield for the capacitive coupling from external interfering electric fields.

9. A multilayer element according to the preceding claim, crossed by one or more metallized holes for the extraction of signals of interest from the respective conductive layers of the front side, the metallized holes on the back side are electrically connected to a fifth conductive layer which forms a conductive pad for welding a connector or an output signal cable, an arrangement at the inlet of a circuitry, for example with functions of conditioning and/or managing the acquired signals, self-powering systems, wireless communication systems, protective snubber networks, the fifth conductive layer being electrically separated, i.e., decoupled, from the third conductive layer.

10. A multilayer element according to any one of the preceding claims, comprising a central portion with a frustoconical shape, from one end of which a series of wavy portions radially extends, being coaxial, i.e., concentric, to the central frustoconical portion.

11. A multilayer element according to the preceding claim, comprising an insulating substrate on a front side of which a first conductive layer, for example with function of analyzing the voltage of the electrical conductor, and a second conductive layer, for example with function of detecting voltage on the electrical conductor, are coupled.

12. A multilayer element according to claim 10 or 11, wherein the back side of the central frustoconical portion is provided with a multipolar connector for mechanically supporting the multilayer element and for transmitting the acquired signals to remote devices.

13. A method for detecting and/or measuring physical quantities associated with a live electrical conductor and at least partially embedded or inserted in a device body made of insulating material, comprising the steps of:
- providing a multilayer element according to any one of claims 1-12;
- positioning the electrical conductor and the multilayer element in a cavity of a mold for the construction of the device body, the multilayer element being placed parallel to or in front of the electrical conductor;
- co-molding the electrical conductor and the multilayer element with the insulating material.

14. A method according to the preceding claim, wherein the multilayer element undergoes a thermoforming and/or electrowelding and/or photoengraving process before it is placed in the mold.

## Patentansprüche

1. Mehrschichtiges Element (50, 100, 200) zum Detektieren und/oder Messen physikalischer Größen, die einem stromführenden elektrischen Leiter zugeordnet sind, wobei das mehrschichtige Element eine ebene oder wellenförmige Form aufweist, um parallel zu oder vor dem elektrischen Leiter unter Bedingungen eines nahen elektrischen Feldes im Mittel- und Hochspannungsbereich positioniert zu werden, und zumindest ein isolierendes Substrat aus einem Mineralfasergewebe wie etwa Glasfaser, eingebettet in eine Matrix aus isolierendem Material, bevorzugt auf Epoxidbasis, und zumindest eine leifähige Schicht, die an eine Seite des isolierenden Substrats gekoppelt ist, aufweist, wobei das isolierende Substrat ebenfalls eine Funktion der mechanischen Halterung für das Mehrschichtelement aufweist,
wobei das mehrschichtige Element **dadurch gekennzeichnet ist, dass** die zumindest eine leitfähige Schicht aus elastischem, leitfähigem Elastomer oder Tinte mit einem niedrigen Oberflächenwiderstand hergestellt ist.

2. Mehrschichtiges Element nach Anspruch 1, wobei zumindest eine leitfähige Schicht die Funktion hat, Feldlinien des von dem stromführenden Leiter erzeugten elektrischen Feldes abzuschirmen und/oder abzulenken, um den Betrieb des mehrschichtigen Elements in einer Schattenzone zu ermöglichen, d.h. im Zustand der Immunität in Bezug auf störende Elementen.

3. Mehrschichtiges Element nach einem der vorstehenden Ansprüche, wobei eine oder mehrere leitfähige Schichten eine RFID-Antenne bilden, die geeignet polarisiert ist und in einer Schattenzone in Bezug auf die gemessene Feldquelle arbeitet.

4. Mehrschichtiges Element nach einem der vorstehenden Ansprüche, mit einer Form, die durch einen Thermoform- und/oder Elektroschweiß- und/oder Fotogravur- und/oder Siebdruckprozess erhalten wird.

5. Mehrschichtiges Element nach einem der vorstehenden Ansprüche, welches auf einer seiner Vorder-/Oberseiten und herum um eine zentrale Öffnung zur Befestigung des mehrschichtigen Elements an einem Träger abwechselnd einen ersten isolierenden Bereich, einen zweiten leitenden Bereich, der eine erste leitfähige Schicht mit kapazitiver Kopplungsfunktion bildet, einen dritten isolierenden Bereich, einen vierten, äußersten leitenden Bereich, der eine zweite leitfähige Schicht mit kapazitiver Kopplung und/oder elektrischer Feldablenk- und/oder elektrischer Abschirmfunktion bildet, aufweist.

6. Mehrschichtiges Element nach dem vorstehenden Anspruch, wobei auf der Rückseite/Unterseite zumindest eine rückseitige leitfähige Schicht ausgebildet ist, die eine Schaltung erzeugt, die für den Schweißprozess von SMD-Bauteilen und/oder einer RFID-Antenne und/oder einem COB-IC und/oder einem elektrischen Pad für SMD-Stecker geeignet ist.

7. Mehrschichtiges Element nach dem vorstehenden Anspruch, wobei ein metallisiertes Durchgangsloch elektrische Kontinuität zwischen der ersten leitfähigen Schicht und der rückseitigen leitfähigen Schicht sicherstellt.

8. Mehrschichtiges Element nach einem der vorstehenden Ansprüche mit einer planaren Struktur mit einer Vorderseite und einer Rückseite, wobei eine erste leitfähige Schicht, welche die Funktion hat, das elektrische Feld durch kapazitive Kopplung zu messen, und eine zweite leitfähige Schicht, welche die Funktion der Spannungsdetektion hat, auf der Vorderseite erhalten werden und koaxial, d.h. konzentrisch zueinander sind und durch eine isolierende Schicht, eine dritte leitfähige Schicht mit elektrischer Abschirmfunktion und eine vierte leitfähige Schicht getrennt sind, die von der dritten leitfähigen Schicht durch eine isolierende Umfangsschicht getrennt ist, die auf der Rückseite erhalten wird, wobei die vierte leitfähige Schicht von der kapazitiven Kopplung in Bezug auf die Source-Elektrode abgeschirmt ist und die Funktion einer Abschirmung für die kapazitive Kopplung von externen störenden elektrischen Feldern hat.

9. Mehrschichtiges Element nach dem vorstehenden Anspruch, das von einem oder mehreren metallisierten Löchern zur Extraktion von interessierenden Signalen von den jeweiligen leitfähigen Schichten der Vorderseite durchzogen ist, wobei die metallisierten Löcher auf der Rückseite elektrisch mit einer fünften leitfähigen Schicht verbunden sind, die ein leitendes Pad zum Anschweißen eines Steckers oder eines Ausgangssignalkabels, einer Anordnung am Eingang eines Schaltkreises, zum Beispiel mit Funktionen zur Konditionierung und/oder Verwaltung der erfassten Signale, selbstversorgender Systeme, drahtloser Kommunikationssysteme, schützender Snubber-Netzwerke usw. bildet, wobei die fünfte leitfähige Schicht von der dritten leitfähigen Schicht elektrisch getrennt, d.h. entkoppelt, ist.

10. Mehrschichtiges Element nach einem der vorstehenden Ansprüche, aufweisend einen zentralen Abschnitt mit einer kegelstumpfförmigen Form, von dessen einem Ende sich eine Reihe wellenförmiger Abschnitte radial erstrecken, die koaxial, d.h. konzentrisch, zu dem zentralen kegelstumpfförmigen Abschnitt sind.

11. Mehrschichtiges Element nach dem vorstehenden Anspruch, aufweisend ein isolierendes Substrat, auf dessen Vorderseite eine erste leitfähige Schicht, zum Beispiel mit der Funktion, die Spannung des elektrischen Leiters zu analysieren, und eine zweite leitfähige Schicht, zum Beispiel mit der Funktion, die Spannung an dem elektrischen Leiter zu detektieren, gekoppelt sind.

12. Mehrschichtiges Element nach Anspruch 10 oder 11, wobei die Rückseite des zentralen kegelstumpfförmigen Abschnitts mit einem mehrpoligen Anschluss zur mechanischen Halterung des mehrschichtigen Elements und zur Übertragung der detektierten Signale an entfernte Vorrichtungen versehen ist.

13. Verfahren zum Detektieren und/oder Messen physikalischer Größen, die einem stromführenden elektrischen Leiter zugeordnet sind und zumindest teilweise in einen Vorrichtungskörper aus isolierendem Material eingebettet oder eingesetzt sind, umfassend die folgenden Schritten:
- Bereitstellen eines mehrschichtigen Elements nach einem der Ansprüche 1-12;
- Positionieren des elektrischen Leiters und des mehrschichtigen Elements in einem Hohlraum einer Form für die Konstruktion des Vorrichtungskörpers, wobei das mehrschichtige Element parallel zu oder vor dem elektrischen Leiter platziert wird;
- gemeinsames Formen des elektrischen Leiters und des mehrschichtigen Elements mit dem isolierendem Material.

14. Verfahren nach dem vorstehenden Anspruch, wobei das mehrschichtige Element einen Thermoform- und/oder Elektroschweiß- und/oder Fotogravur-Prozess durchläuft, bevor es in der Form platziert wird.

## Revendications

1. Élément multicouche (50, 100, 200) pour détecter et/ou mesurer des quantités physiques associées à un conducteur électrique sous tension, l'élément multicouche présentant une forme plane ou ondulée de manière à être positionné parallèlement au conducteur électrique ou devant celui-ci, dans des conditions de champ électrique proche dans le domaine de moyennes tensions et de hautes tensions et comprenant au moins un substrat isolant constitué d'un maillage de fibres minérales, comme des fibres de verre, intégré dans une matrice de matériau isolant, de préférence à base d'époxy, et au moins une couche conductrice couplée à un côté du substrat isolant, dans lequel le substrat isolant présente également une fonction de support mécanique pour l'élément multicouche,
l'élément multicouche étant **caractérisé en ce que** la couche conductrice, au moins au nombre de une, est fabriquée à partir d'un élastomère élastique conducteur ou d'une encre présentant une faible résistivité de surface.

2. Élément multicouche selon la revendication 1, dans lequel au moins une couche conductrice présente la fonction de protection et/ou de déviation de lignes de champ du champ électrique généré par le conducteur sous tension de manière à permettre le fonctionnement de l'élément multicouche dans une zone d'ombre, c'est-à-dire dans une condition d'immunité par rapport à des éléments interférents.

3. Élément multicouche selon l'une quelconque des revendications précédentes, dans lequel une ou plusieurs couches conductrices forment une antenne RFID polarisée de manière appropriée et fonctionnant dans une zone d'ombre par rapport à la source de champ mesurée.

4. Élément multicouche selon l'une quelconque des revendications précédentes, présentant une forme obtenue par un processus de thermoformage et/ou d'électrosoudage et/ou de photogravure et/ou de sérigraphie.

5. Élément multicouche selon l'une quelconque des revendications précédentes, comprenant, sur l'un des côtés avant/supérieur de celui-ci et en alternance mutuellement autour d'une ouverture centrale pour fixer l'élément multicouche à un support, une première surface isolante, une deuxième surface conductrice qui forme une première couche conductrice présentant une fonction de couplage capacitif, une troisième surface isolante, et une quatrième surface conductrice la plus extérieure, qui forme une deuxième couche conductrice présentant une fonction de couplage capacitif et/ou de déviation de champ électrique et/ou de protection électrique.

6. Élément multicouche selon la revendication précédente, dans lequel au moins une couche conductrice arrière est formée sur le côté arrière/inférieur de celui-ci, qui crée un montage approprié pour le processus de soudage de composants SMD et/ou une antenne RFID et/ou un circuit intégré COB et/ou une pastille de connexion électrique pour connecteur SMD.

7. Élément multicouche selon la revendication précédente, dans lequel un trou traversant métallisé assure une continuité électrique entre la première couche conductrice et la couche conductrice arrière.

8. Élément multicouche selon l'une quelconque des revendications précédentes, présentant une structure plane avec un côté avant et un côté arrière, dans lequel une première couche conductrice présentant une fonction de mesure du champ électrique par couplage capacitif et une deuxième couche conductrice présentant une fonction de détection de tension sont obtenues sur le côté avant, en étant coaxiales, c'est-à-dire concentriques l'une avec l'autre, et séparées par une couche isolante, une troisième couche conductrice avec une fonction de protection électrique, une quatrième couche conductrice, séparée de la troisième couche conductrice par une couche périmétrique isolante, étant obtenue sur le côté arrière, ladite quatrième couche conductrice étant protégée contre le couplage capacitif par rapport à l'électrode de source et présentant la fonction d'une protection contre le couplage capacitif de champs électriques interférents externes.

9. Élément multicouche selon la revendication précédente, traversé par un ou plusieurs trous métallisés pour l'extraction de signaux d'intérêt à partir des couches conductrices respectives du côté avant, les trous métallisés sur le côté arrière étant reliés électriquement à une cinquième couche conductrice qui forme une pastille conductrice pour le soudage d'un connecteur ou d'un câble de signal de sortie, un agencement à l'entrée d'un montage, par exemple avec des fonctions de conditionnement et/ou de gestion des signaux acquis, des systèmes d'auto-alimentation, des systèmes de communication sans fil, des réseaux amortisseurs protecteurs, la cinquième couche conductrice étant séparée électriquement, c'est-à-dire découplée, de la troisième couche conductrice.

10. Élément multicouche selon l'une quelconque des revendications précédentes, comprenant une partie centrale de forme tronconique présentant une extrémité à partir de laquelle une série de parties ondulées s'étendent radialement en étant coaxiales à, c'est-à-dire concentriques avec, la partie tronconique centrale.

11. Élément multicouche selon la revendication précédente, comprenant un substrat isolant présentant un côté avant sur lequel une première couche conductrice, par exemple présentant une fonction d'analyse de la tension du conducteur électrique, et une deuxième couche conductrice, par exemple présentant une fonction de détection de tension sur le conducteur électrique, sont couplées.

12. Élément multicouche selon la revendication 10 ou 11, dans lequel le côté arrière de la partie tronconique centrale est pourvu d'un connecteur multipolaire pour supporter mécaniquement l'élément multicouche et pour transmettre les signaux acquis vers des dispositifs distants.

13. Procédé de détection et/ou de mesure de quantités physiques associées à un conducteur électrique sous tension et au moins partiellement intégré ou inséré dans un corps de dispositif constitué de matériau isolant, comprenant les étapes suivantes :
- la fourniture d'un élément multicouche selon l'une quelconque des revendications 1 à 12 ;
- le positionnement du conducteur électrique et de l'élément multicouche dans une cavité d'un moule pour la construction du corps de dispositif, l'élément multicouche étant placé parallèlement au conducteur électrique ou devant celui-ci ;
- le co-moulage du conducteur électrique et de l'élément multicouche avec le matériau isolant.

14. Procédé selon la revendication précédente, dans lequel l'élément multicouche subit un processus de thermoformage et/ou d'électrosoudage et/ou de photogravure avant d'être placé dans le moule.
